# EUROPÄISCHE PATENTSCHRIFT

(11) **EP 0 626 100 B1**
(45) Veröffentlichungstag und Bekanntmachung des Hinweises auf die Patenterteilung: **07.10.1998**
(21) Anmeldenummer: 93905236.1
(22) Anmeldetag: 10.02.1993
(51) Int. Cl.: H01L 29/06, H01L 27/04, H01L 21/822

(54) **VERFAHREN ZUR HERSTELLUNG EINER HALBLEITERSTRUKTUR**
PROCESS FOR PRODUCING A SEMICONDUCTOR STRUCTURE
PROCEDE DE FABRICATION D'UNE STRUCTURE A SEMICONDUCTEUR ET STRUCTURE A SEMICONDUCTEUR FABRIQUEE SELON LE PROCEDE

(30) Priorität: 12.02.1992 DE 4204004
(43) Veröffentlichungstag der Anmeldung: 30.11.1994
(73) Patentinhaber: Daimler-Benz Aktiengesellschaft, 70546 Stuttgart (DE)
(72) Erfinder: BODENSOHN, Alexander Dipl.-Ing, 63512 Hainburg (DE); HENKEL, Heinz, 63179 Obertshausen (DE)
(86) Internationale Anmeldenummer: EP9300319
(87) Internationale Veröffentlichungsnummer: WO9317459

(56) Entgegenhaltungen:
- EP-A- 147 626
- EP-A- 191 476
- EP-A- 193 172
- EP-A- 217 288
- EP-A- 316 799
- WO-A-93/11561

## Beschreibung

Die Erfindung betrifft ein Verfahren zur Herstellung einer Halbleiterstruktur mit mehreren vertikalen und mindestens einem lateralen Halbleiterbauelement, die in einem scheibenförmigen Halbleiterkörper mit einer ersten und einer ihr gegenüberliegenden zweiten Oberfläche integriert sind, wobei unterhalb der ersten Oberfläche mindestens ein laterales Halbleiterbauelement angeordnet wird und die vertikalen Halbleiterbauelemente sich zwischen der ersten und der zweiten Oberfläche erstrecken. Die Dicke des Halbleiterkörpers ist im Bereich der Teilstruktur vermindert.

Ein derartiges Verfahren zur Herstellung einer Halbleiterstruktur geht aus der EP-A-0 193 172 hervor. Dort ist ein vertikaler MOS-Transistor beschrieben, der in einem Halbleiterkörper neben einem lateralen Schaltkreis angeordnet ist. Der MOS-Transistor und der laterale Schaltkreis sind durch einen pn-Übergang gegeneinander isoliert. Aus dem genannten Dokument geht nicht hervor, mehrere vertikale Bauelemente in dem Halbleiterkörper zu integrieren. Nachteilig ist bei der genannten Art der Isolierung, daß die bei dem pn-Übergang vorhandene Raumladungszone viel Platz beansprucht, der nicht für die Einfügung von Bauelementen genutzt werden kann. Außerdem kann die Dotierung der neben der Isolierung liegenden Bereiche nicht frei gewählt werden, es muß nämlich - für die Entstehung einer Raumladungszone - stets eine p-dotierte und eine n-dotierte Zone im Wechsel vorhanden sein, damit ein pn-Übergang entsteht. Ferner ist nachteilig, daß bei einem pn-Übergang stets auf die richtige Polung (in Sperrichtung) geachtet werden muß, da ansonsten die isolierende Wirkung des Übergangs verlorengeht. Das erlaubte Potential in dem einen Bereich ist also abhängig von dem in dem anderen - hinter dem pn-Übergang liegenden - Bereich.

Aus der internationalen Anmeldung WO09311561 ist eine integrierte Halbleiterstruktur bekannt, bei der mehrere vertikale Leistungsbauelemente und mindestens ein laterales Halbleiterbauelement zum Ein- und Ausschalten vorgesehen sind. Die vertikalen Halbleiterbauelemente erstrecken sich zwischen einer ersten und einer zweiten Oberfläche eines Halbleiterkörpers. Unter der ersten Oberfläche sind die lateralen Halbleiterbauelemente in einer Teilstruktur angeordnet, die von einer isolierenden Wand umgeben ist. Im Bereich der Teilstruktur ist die Dicke des Halbleiterkörpers von der zweiten Oberfläche bis zur isolierenden Wand vermindert. Der Boden der Ausnehmung ist mit einer isolierenden Schicht bedeckt.

Aus der EP-A-O 147 626 ist eine Halbleiterstruktur mit einem integrierten lateralen und einem integrierten vertikalen Halbleiterbauelement bekannt. Isolierende Zwischenwände trennen die Halbleiterbauelemente voneinander. Die Zwischenwände erstrecken sich von der einen Oberfläche bis ins Innere des Halbleiterkörpers. Die Halbleiterstruktur unterhalb der lateralen Bauelemente mit einer Ausnehmung zu versehen, die bis zu den isolierenden Zwischenwänden reicht, ist nicht beschrieben.

Der Erfindung liegt die Aufgabe zugrunde, ein Verfahren zur Herstellung einer Halbleiterstruktur mit mehreren integrierten Halbleiterbauelementen zu nennen, die auf engstem Raume neben mindestens einem lateralen Halbleiterbauelement mehrere unabhänig davon betreibbare vertikale Halbleiterbauelemente enthält.

Die Aufgabe für das Verfahren wird erfindungsgemäß durch das Verfahren zur Herstellung einer Halbleiterstruktur nach Anspruch 1 gelöst.

Bei dem Verfahren treten keinerlei Beschädigungen in der Kristallstruktur auf. Zur Herstellung der Halbleiterstruktur werden bekannte Diffusionsverfahren verwendet, wobei auch die Kontaktierung und die Passivierung vorbestimmter Oberflächenbereiche mit üblichen Verfahrensmaßnahmen durchgeführt werden können. Das Verfahren ermöglicht die Verwendung von gleichen Teilstrukturen für Leistungs- und Signalbauelemente. Die vertikalen Bauelemente unterscheiden sich von lateralen unter anderem in der Dotierung der tieferen Schichten. Halbleiterstruktur ist so auslegbar, daß innerhalb der Teilstrukturen laterale Halbleiterbauelemente angeordnet sind, die als Signalelemente für außerhalb der Teilstrukturen platzierte vertikale Leistungsbauelemente dienen. Andere Weiterbildungen der Erfindung sind den Unteransprüchen zu entnehmen.

Es zeigen
- Fig. 1: einen scheibenförmigen Halbleiterkörper mit bereits erzeugten Teilstrukturen vor der Aufteilung in die Bereiche für die lateralen und die vertikalen Bauelemente;
- Fig. 2: den Halbleiterkörper nach dem Einbringen einer Ausnehmung;
- Fig. 3: den Halbleiterkörper nach weiteren Prozeßschritten;
- Fig. 4: die Weiterverarbeitung des Halbleiterkörpers an der ersten Oberfläche;
- Fig. 5: den Halbleiterkörper nach der Weiterverarbeitung an der zweiten Oberfläche;
- Fig. 6: den Halbleiterkörper mit der Struktur aus lateralen und vertikalen Bauelementen;
- Fig. 7: einen weiteren Halbleiterkörper nach dem Trockenätzen von Isoliergräben;
- Fig. 8: den Halbleiterkörper gem. Fig. 7 nach einem weiteren Prozeßschritt;
- Fig. 9: den Halbleiterkörper gem. Fig. 7 nach dem Entstehen eines Testfensters und
- Fig. 10: einen scheibenförmigen Halbleiterkörper mit mehreren vertikalen Leistungsbauelementen.

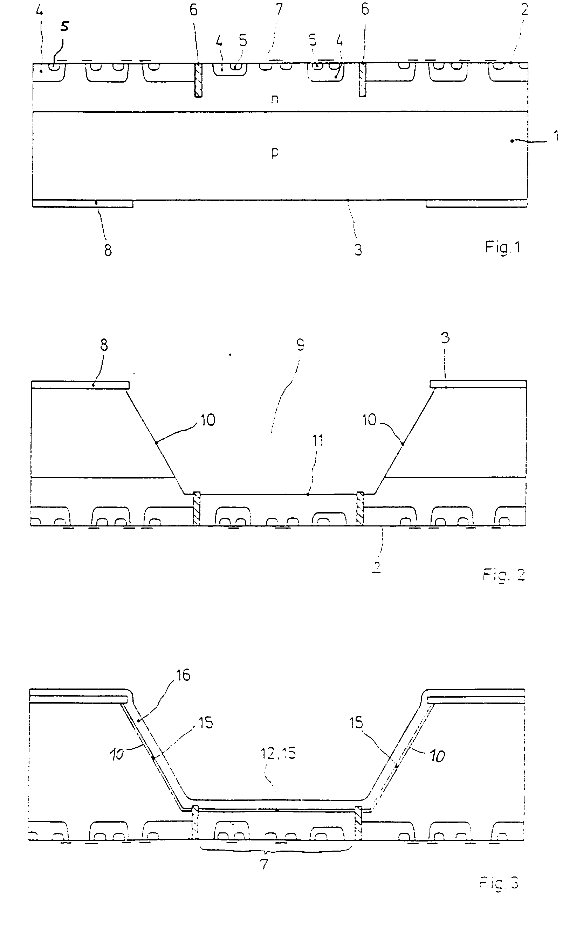

Bei dem Ausführungsbeispiel wird in Fig. 1 von einem scheibenförmigen Halbleiterkörper (1) aus Silizium ausgegangen, welcher eine erste Oberfläche (2) und eine zweite Oberfläche (3) aufweist. Durch Diffusion werden zunächst Bereiche (4) erzeugt, in welche durch einen weiteren Diffusionsschritt Teilbereiche (5) eingelassen sind. Hierbei handelt es sich Bereiche (4) und Teilbereiche (5), die für die Integrierung sowohl von lateralen Halbleiterbauelementen als auch von vertikalen Halbleiterbauelementen angelegt werden. Bei der Herstellung von mehreren lateralen Halbleiterbauelementen unterhalb der Obenfläche (2) des Halbleiterkörpers (1) ist es üblich, diese Halbleiterbauelemente in ihrer Umgebung gegenüber Nachbarbereichen des Halbleiterkörpers (1) zu isolieren, damit sie unabhängig von benachbarten Halbleiterbauelementen in Funktion treten können. Zur seitlichen Isolation werden dazu zunächst isolierende Wände (6) bis zu einer bestimmten Tiefe erzeugt, die die Teilstruktur (7) ringsum seitlich umgeben.

Diese isolierenden Wände (6) werden in bekannter Weise dadurch hergestellt, daß Gruben durch Plasmaätzen erzeugt werden, die anschließend mit einem isolierenden Material aufgefüllt werden. Ferner wird auf der zweiten Oberfläche (3) eine Ätzmaske (8) aufgebracht. Da die Fig. 1 wie auch die weiteren Figuren nur Teilausschnitte eines Halbleiterkörpers (1) mit mehreren Strukturbereichen darstellen, sind auf dem gesamten Halbleiterkörper (1) mehrere Teilstrukturen (7) vorhanden, so daß die Ätzmaske (8) dementsprechend zu strukturieren ist, daß jeweils der unterhalb der Teilstruktur (7) liegende Bereich der Oberfläche (3) nicht von der Ätzmaske (8) bedeckt ist.
Die vertikalen Halbleiterbauelemente unterscheiden sich von den lateralen unter anderem in der Dotierung der tieferen Schichten und sind Leistungsbauelemente, während die lateralen Halbleiterbauelemente Signalbauelemente sind.

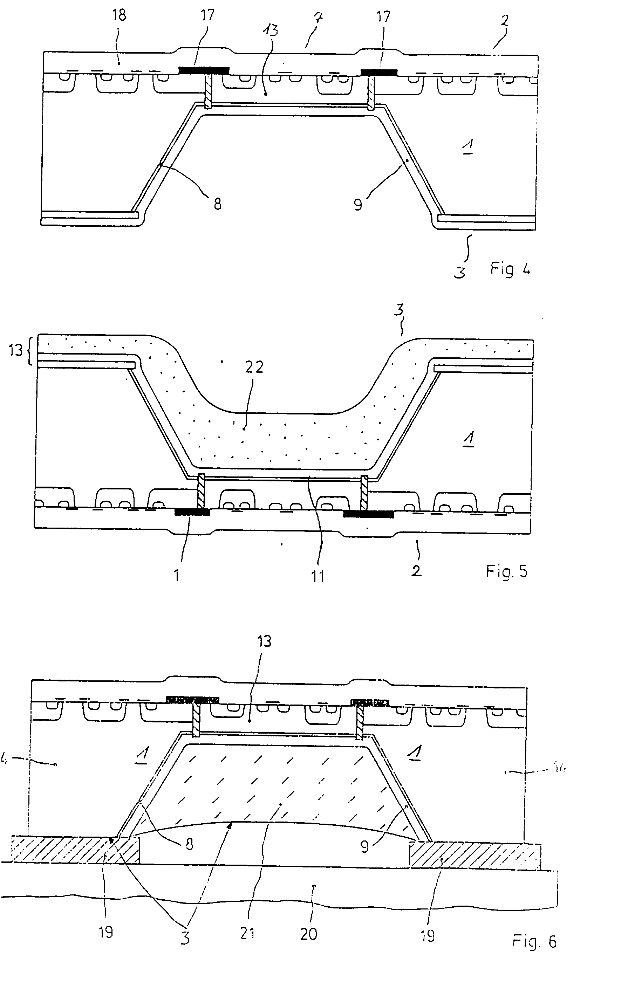

In Fig. 2 wird die Herstellung einer Ausnehmung (9) erläutert. In dem Ausführungsbeispiel soll die Ausnehmung (9) durch einen anisotropen Ätzprozeß erzeugt werden. Dazu wird ein Halbleiterkörper (1) verwendet, dessen Oberfläche (3) eine <100>-Ebene darstellt. Zum Ätzen wird eine KOH-Lösung verwendet, die das Material derart angreift, daß die Seitenwände (10) eine <111>-Ebene sind. Durch den Ätzprozeß wird die Dicke des Halbleiterkörpers (1) in dem Bereich der Ausnehmung (9) vermindert, und zwar so weit, daß der Boden (11) der Ausnehmung (9) bis an die Wände (6) heranreicht und sich dadurch eine Siliziummembran bildet, deren Dicke ungefähr gleich der Tiefe der Wände (6) ist.

Zur Vereinfachung und besseren Handhabung kann auf der Rückseite, also auf der Oberfläche (2), bei Bedarf vorübergehend eine Verstärkung der Siliziummembran, beispielsweise eine Schicht aus Polyimid, aufgetragen werden.

Der Boden (11) wird mit einer elektrisch isolierenden Schicht (12) bedeckt, beispielsweise einer Siliziumoxidschicht, wie es in Fig. 3 dargestellt ist. Die Teilstruktur (7) ist nunmehr allseitig gegen ihre Umgebung elektrisch isoliert und stellt bis auf die Kontaktierung ein laterales Halbleiterbauelement dar.

Um eine noch bessere funktionale Trennung der integrierten Halbleiterbauelemente zu erzielen, ist es günstig, nicht nur der Boden (11) der Ätzgrube (9), sondern auch deren Wände (10) mit einer Oxidschicht zu bedecken, die in Fig. 3 mit dem Bezugszeichen (15) versehen ist. Wenn diese Oxidschicht durch thermische Oxidation erzeugt wird, werden die Oberflächenbereiche, die nicht oxidiert werden sollen, durch eine Si3N4-Schicht abgedeckt. Die Oxidschicht (15) wird dann noch mit einer elektrisch schlecht leitenden Schicht (16) (Passivierungschicht) bedeckt, die z. B. aus amorphem Kohlenstoff oder amorphem Siliziumcarbid bestehen kann. Diese Materialien sind elektrisch schlecht leitend, weisen jedoch eine gute Wärmeleitfähigkeit auf und sollen im wesentlichen zur Abführung der Verlustwärme der Bauelemente dienen. Es ist auch möglich, diese schlecht leitende Schicht (16) direkt ohne vorherige Oxidation aufzubringen, dann kann der Halbleiterkörper (1) wegen fehlender Oxidation bei hoher Temperatur weitgehend vor dem anisotropen Ätzen fertig prozessiert werden. Da die Metallisierung und die Passivierung schon vor dem Ätzen aufgebracht und strukturiert werden können, wird der Prozeß vereinfacht.

Wie in Fig. 4 dargestellt, dienen Kontakte (17) zur Kontaktierung der Teilstruktur (7), wodurch die lateralen Halbleiterbauelemente (13) funktionsgerecht fertiggestellt sind. Gleichzeitig mit den Kontakten (17) werden auch die Kontakte von außerhalb der Teilstruktur (7) befindlichen vertikalen Halbleiterbauelementen aufgebracht und strukturiert. Die Oberfläche (2) wird dann noch mit einer Passivierungsschicht (18) überzogen.

Anschließend wird die Oberfläche (3) mit Fotolack (22) (Fig. 5) - gegebenenfalls mehrmals - bedeckt. Der Fotolack (22) wird so aufgetragen, daß die Ätzgrube (9) mit einer dickeren Schicht bedeckt ist als die Bereiche auf der zweiten Oberfläche (3). Als nächster Verfahrensschritt schließt sich ein Trockenätzprozeß an, in dem das Schichtsystem aus Fotolack (22), der elektrisch schlecht leitenden Schicht (16) und der Si3N4-Schicht bis auf einen Teil der Schicht in der Ätzgruppe (9) entfernt wird. Aufgrund der dickeren Schicht in der Ätzgruppe (9) wird nämlich nur eine Teilschicht abgetragen. Bei diesem Trockenätzprozeß wird die Oberfläche (3) des Halbleiterkörpers (1) freigelegt und steht damit für selektive Kontaktierungssysteme oder zur Herstellung von Legierungskontakten zur Verfügung.

Die Fig. 6 zeigt einen Halbleiterkörper (1) mit einer auf die vorstehend angegebene Art hergestellten Kontaktierung. Der Halbleiterkörper (1) wird hierbei auf einen Träger (20) mit strukturierter Metallisierung (19), z. B. Gold, aufgebracht. In einem Legierungsprozeß verbindet sich das Silizium und die Metallsierung, so daß es zu einem Kontakt mit hoher Qualität kommt.

Zur Verstärkung der Silizummembran - also des Bodens (11) der Ausnehmung (9) - kann vor dem Kontaktieren ein Füllmaterial (21) - beispielsweise Fotolack - aufgebracht werden, wodurch Druckbelastungen und mechanische Einflüsse gedämpft werden. Bei dem weiter oben erwähnten Fotolack (22) handelt es sich um eine nur zeitweise genutzte Schicht, welche die selektive selbstjustierende Strukturierung (Trockenätzprozeß) der Oberfläche (3) unterstützt und die Stabilität des geätzten Halbleiterkörpers (1) für die Dauer der daran anschließenden Verfahrensschritte gewährleistet. Demgegenüber ist das Füllmaterial (21) eine dauerhafte Unterstützung der Silizummembran und erleichtert gegebenenfalls eine strukturierte Metallisierung der Oberfläche (3) bei üblichen fotolitographischen Verfahren.

Es ist für nicht selektive Metallisierungen auch möglich, die Oberfläche (3) zu planarisieren. Dann kann die den lateralen Bauelementen (13) abgewandte Oberfläche (3) des Halbleiterkörpers (1) vollständig metallisiert und anschließend strukturiert werden.

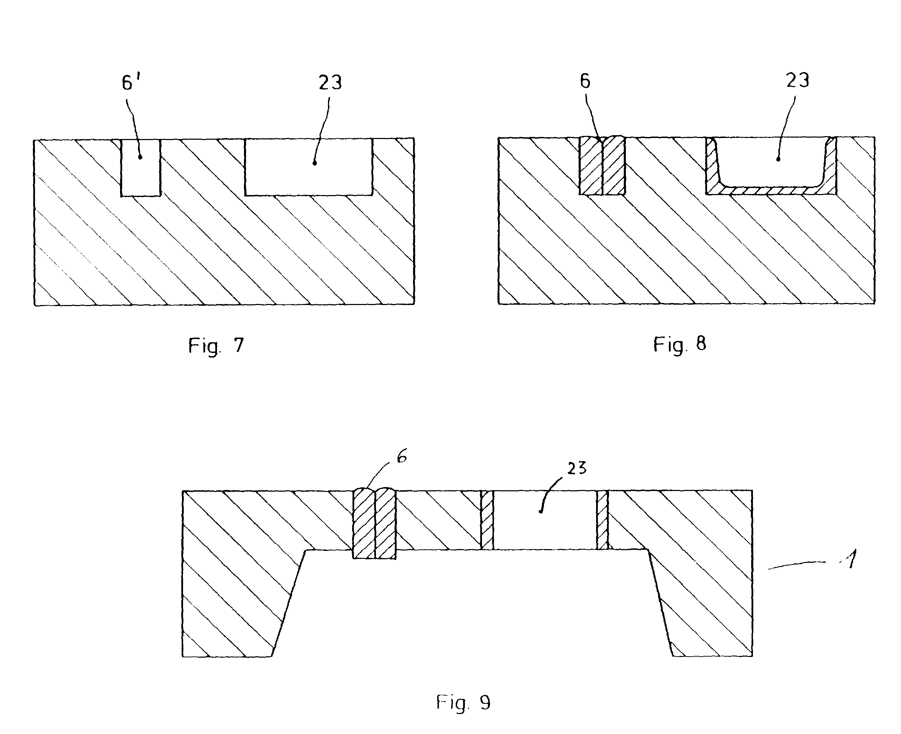

Die Fig. 7 zeigt eine Siliziumscheibe mit einem Trenngraben (6') (selbstverständlich ist auch die Einfügung mehrerer Trenngräben (6') denkbar). Zusätzlich zu dem Trenngraben (6') ist eine Ausnehmung bzw. ein weiterer Graben vorhanden. Der Graben hat die gleiche Tiefe wie der Trenngraben (6') aber eine größere Breite als dieser. Dieser Graben ist in den Figuren 7 und 8 als Testfenster (23) bezeichnet. Der Trenngraben (6') und das Testfenster (23) werden aufgefüllt, allerdings wird wegen der größeren Öffnung des Testfensters (23) dieses im Gegensatz zu dem Trenngraben (6') nicht vollständig aufgefüllt. Deshalb bleibt nach dem folgenden planarisierenden Oxidätzen am Boden des Testfensters (23) nur eine dünne Oxidschicht erhalten.

Die Fig. 9 zeigt die Siliziumscheibe mit dem Testfenster (23) nach dem anisotropen Ätzen.

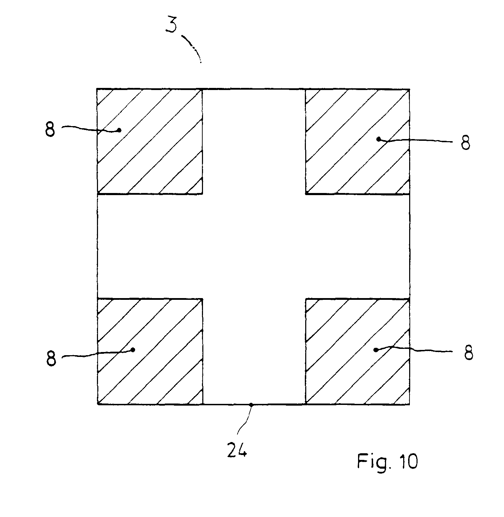

Die beiden Strukturen sind in Fig. 9 nach dem anisotropen Ätzen gezeigt. Wenn die Ätzgruben die Testfenster (23) erreichen, entstehen wegen der nur dünnen Schicht Durchbrüche, die durch Augenschein erkennbar sind. Da die Testfenster (23) die gleiche Tiefe wie die Trenngräben (6') haben, kann so das Ätzen gesteuert werden. Durch die Durchbrüche in den Testfenstern (23) wird das spätere Belacken des Halbleiterkörpers (1) beeinträchtigt, deshalb sind diese Teststrukturen bevorzugt im Randbereich des Halbleiterkörpers (1) zu platzieren.
Mit der Erfindung ist es möglich, eine Halbleiterstruktur mit mehreren integrierten vertikalen Halbleiterbauelenten zu erzeugen, indem eine entsprechende Struktur vorgesehen wird. Die Fig. 10 zeigt die zweite Oberfläche (3) einer Halbleiterscheibe (24), die vier Leistungsbauelemente hat, deren Ätzmasken (8) zu erkennen sind. Insbesondere lassen sich durch eine symmetrische Anordnung der Leistungsbauelemente zwei oder mehrere solcher Bauelemente in dem gleichen Halbleiterkörper unterbringen. Die Leistungsbauelemente sind insbesondere an den Ecken des quaderförmigen Halbleiterkörpers angeordnet. Gemäß Fig. 10 weist jede Ecke ein vertikales Leistungsbauelement auf.

Bei der nach dem oben beschriebenen Verfahren hergestellten Halbleiterstruktur werden Äquipotentialflächen durch eine isolierende Rückseite der Siliziummembran - also durch eine Isolierung der Oberfläche (3) in Höhe der Ausnehmung (9) - günstig beeinflußt. Dadurch ist es auch möglich, laterale Halbleiterbauelemente für hohe Spannungen (z. B. 1 000 V) in der Teilstruktur (7) - innerhalb der dünnen Membran - und übliche, monolithisch integrierte Halbleiterschaltungen in Bereichen außerhalb der Teilstruktur (7) auszubilden.

## Patentansprüche

1. Verfahren zur Herstellung einer Halbleiterstruktur mit mehreren vertikalen (13) und mindestens einem lateralen Halbleiterbauelement (14), die in einem scheibenförmigen Halbleiterkörper (1) mit einer ersten (2) und einer ihr gegenüberliegenden zweiten Oberfläche (3), integriert sind, wobei unterhalb der ersten Oberfläche mindestens ein laterales Halbleiterbauelement (13) angeordnet wird und die vertikalen Halbleiterbauelemente (14) sich zwischen der ersten und der zweiten Oberfläche erstrecken, mit folgenden Verfahrensschritten:
a) Bilden mindestens einer Teilstruktur (7) mit mindestens einem lateralen Halbleiterbauelement (13) im Halbleiterkörper (1) an der ersten Oberfläche (2);
b) Bilden mehrerer dotierter Bereiche (4) und darin eingebetteter Teilbereiche (5) außerhalb der mindesten einen Teilstruktur (7);
c) Umgeben der mindesten einen Teilstruktur (7) mit mindestens einer vertikalen, elektrisch isolierenden Wand (6), die sich bis zu einer bestimmten Tiefe von der ersten Oberfläche (2) her in den Halbleiterkörper (1) erstreckt,
d) Vermindern der Dicke des Halbleiterkörpers (1) von der zweiten Oberfläche (3) her im Bereich der mindesten einen Teilstruktur (7) bis zu jeder isolierenden Wand (6), wodurch jeweils eine Ausnehmung (9) in dem Halbleiterkörper (1) entsteht,
e) Aufbringen einer isolierenden Schicht auf dem Boden jeder Ausnehmung (9) und
f) strukturiertes Metallisieren und/oder Passivieren der ersten und zweiten Oberfläche (2, 3) derart, daß mindestens ein laterales Bauelement (13) im Bereich oberhalb des Bodens (11) jeder Ausnehmung (9) und vertikale Bauelemente (14) außerhalb der Ausnehmungen (9) entstehen.

2. Verfahren nach Anspruch 1,
dadurch gekennzeichnet,
daß die zweite Oberfläche (3) eine <100>-Ebene ist, daß die Ausnehmung(en) (9) durch Ätzen erzeugt werden und daß als Ätzlösung eine KOH-Lösung verwendet wird, wobei an der/den Ausnehmung(en) (9) Wände entstehen, die in <111>-Ebenen liegen.

3. Verfahren nach einem der Ansprüche 1 oder 2,
dadurch gekennzeichnet,
daß eine der mindesten einen Teilstruktur (7) einen weiteren Bereich (4) aufweist, der den entgegengesetzten Leitungstyp wie das Ausgangsmaterial des Halbleiterkörpers (1) aufweist.

4. Verfahren nach Anspruch 3,
dadurch gekennzeichnet,
daß in dem weiteren Bereich (4) Teilbereiche (5) vorbestimmten Leitungstyps und vorbestimmter Dotierungskonzentration eingelassen sind, welche den Bauelementtyp bestimmen.

5. Verfahren nach einem der vorangehenden Ansprüche,
dadurch gekennzeichnet,
daß zur Herstellung der mindesten einen elektrisch isolierenden Wand (6) entsprechende Gruben durch Plasma-Ätzen erzeugt werden und daß die Gruben anschließend mit einem elektrisch isolierenden Material gefüllt werden.

6. Verfahren nach einem der vorangehenden Ansprüche,
dadurch gekennzeichnet,
daß der Boden (11) jeder Ausnehmung (9) mit einer Siliziumoxidschicht (15) bedeckt wird.

7. Verfahren nach einem der Ansprüche 1 bis 5,
dadurch gekennzeichnet,
daß die Wände (10) und der Boden (11) jeder Ausnehmung (9) mit einer Siliziumoxidschicht (15) bedeckt werden.

8. Verfahren nach Anspruch 6 oder 7,
dadurch gekennzeichnet,
daß die Bereiche des Halbleiterkörpers (1), die nicht oxidiert werden sollen, zunächst mit einer Si3N4-Schicht abgedeckt werden, bevor die Siliziumoxidschicht (15) durch thermische Oxidation erzeugt wird.

9. Verfahren nach einem der Ansprüche 6 bis 8,
dadurch gekennzeichnet,
daß die Siliziumoxidschicht (15) mit einer elektrisch nicht leitenden Schicht (16) überzogen wird.

10. Verfahren nach einem der vorangehenden Ansprüche,
dadurch gekennzeichnet,
daß jede Ausnehmung (9) zumindest teilweise mit einem Füllmaterial (21) ausgefüllt wird.

11. Verfahren nach einem der vorhergehenden Ansprüche,
dadurch gekennzeichnet,
daß im Halbleiterkörper (1) wenigstens ein als Testfenster (23) dienender Graben erzeugt wird, der in der Tiefe mit den Trenngräben (6') für die elektrisch isolierenden Wände (6) übereinstimmt und breiter als diese ausgebildet ist und daß die Dicke des Halbleiterkörpers (1) vermindert wird, bis der Boden des Grabens durchbrochen ist.

## Claims

1. Method of producing a semiconductor structure with several vertical (13) and at least one lateral semiconductor element (14), which are integrated in a slice-like semiconductor body (1) with a first surface (2) and a second surface (3) disposed opposite thereto, wherein at least one lateral semiconductor element (13) is arranged below the first surface and the vertical semiconductor elements (14) extend between the first and the second surface, comprising the following method steps:
a) forming at least one partial structure (7) with at least one lateral semiconductor element (13) in the semiconductor body (1) at the first surface (2);
b) forming several doped regions (4) and partial regions (5) embedded therein outside the at least one partial structure (7);
c) surrounding the at least one partial structure (7) by at least one vertical, electrically insulating wall (6), which extends to a specific depth from the first surface (2) into the semiconductor body (1);
d) reducing the thickness of the semiconductor body (1) from the second surface (3) in the region of the at least one partial structure (7) up to each insulating wall (6), whereby a recess (9) arises each time in the semiconductor body (1);
e) applying an insulating layer on the base of each recess (9) and
f) structured metallising and/or passivating the first and second surface (2,3) in such a manner that at least one lateral structural element (13) arises in the region above the base (11) of each recess (9) and vertical structural elements (14) arise outside the recesses (9).

2. Method according to claim 1, characterised thereby that the second surface (3) is a <100> plane, that the recess(es) (9) is or are produced by etching and that a KOH solution is used as etching solution, wherein walls, which lie in the <III> planes, arise at the recess(es).

3. Method according to one of claims 1 and 2, characterised thereby that the at least one partial structure (7) has a further region (4), which has the opposite conductivity type as the starting material of the semiconductor body (1).

4. Method according to claim 3, characterised thereby that partial regions (5) of predetermined conductivity type and predetermined doping concentration, which determine the structural element type, and let into the further region (4).

5. Method according to one of the preceding claims, characterised thereby that for producing the at least one electrically insulating wall (6) corresponding trenches are produced by plasma etching and that the trenches are subsequently filled with an electrically insulating material.

6. Method according to one of the preceding claims, characterised thereby that the base (11) of each recess (9) is covered by a silicon oxide layer (15).

7. Method according to one of claims 1 to 5, characterised thereby that the walls (10) and the base (11) of each recess (9) are covered by a silicon oxide layer (15).

8. Method according to claim 6 or 7, characterised thereby that the regions of the semiconductor body (1) which are not to be oxidised are initially covered with a Si3N4 layer before the silicon oxide layer (15) is produced by thermal oxidation.

9. Method according to of claims 6 to 8, characterised thereby that the silicon oxide layer (15) is coated with an electrically non-conductive layer (16).

10. Method according to one of the preceding claims, characterised thereby that each recess (9) is at least partly filled with a filler material (21).

11. Method according to one of the preceding claims, characterised thereby that at least one trench, which in depth corresponds with the separating trenches (6') for the electrically insulating walls (6) and is formed to be wider than these and which serves as a test window (23), is formed in the semiconductor body (1) and that the thickness of the semiconductor body (1) is reduced until the base of the trench is broken through.

## Revendications

1. Procédé de fabrication d'une structure à semiconducteur comportant plusieurs composants à semiconducteur verticaux (13) et au moins un composant à semiconducteur latéral (14), qui sont intégrés dans un bloc à semiconducteur (1) en forme de plaquette, présentant une première surface (2) et une seconde surface (3) opposée à la première, étant précisé qu'en dessous de la première surface est disposé au moins un composant à semiconducteur latéral (13) et que les composants à semiconducteur verticaux (14) s'étendent entre la première et la seconde surfaces, comportant les pas de procédé suivants:
a) former dans le bloc à semiconducteur (1), contre la première surface (2), au moins une structure partielle (7) présentant au moins un composant à semiconducteur latéral (3);
b) former en dehors de la structure partielle (7) dont il y a au moins une plusieurs zones dopées (4) et des zones partielles (5) qui y sont enrobées;
c) entourer la structure partielle (7), dont il y a au moins une, d'au moins une paroi verticale (6) électriquement isolante, qui s'étend dans le bloc à semiconducteur (1), jusqu'à une profondeur déterminée depuis la première surface (2),
d) réduire l'épaisseur du bloc à semiconducteur (1) dans la zone de la structure partielle (7) dont il y a au moins une, depuis la seconde surface (3) jusqu'à chaque paroi isolante (6), ce par quoi apparaît chaque fois un évidement (9) dans le bloc à semiconducteur (1),
e) appliquer une couche isolante sur le fond de chaque évidement (9) et
f) réaliser une métallisation et/ou une passivation structurée de la première et de la seconde surfaces (2, 3) de façon qu'apparaissent au moins un composant latéral (13) dans la zone située au-dessus du fond (11) de chaque évidement (9) et des composants verticaux (14) à l'extérieur des évidements (9).

2. Procédé selon la revendication 1,
caractérisé
par le fait que la seconde surface (3) est un plan <100>, que l'on obtient l'évidement (les évidements) (9) par décapage et que comme solution de décapage on emploie une solution de KOH, étant précisé que dans l'évidement (les évidements) (9) apparaissent des parois situées dans des plans (111).

3. Procédé selon l'une des revendications 1 ou 2,
caractérisé
par le fait que l'une des structures partielles (7) dont il y a au moins une présente une autre zone (4) qui présente le type de conduction opposé à celui du matériau initial du bloc à semiconducteur (1).

4. Procédé selon la revendication 3,
caractérisé
par le fait que dans l'autre zone (4) sont insérées les zones partielles (5) de type de conduction déterminé et de concentration de dopage déterminée, qui déterminent le type de composants.

5. Procédé selon l'une des revendications précédentes,
caractérisé
par le fait que pour fabriquer la paroi électriquement isolante (6) dont il y a au moins une, on produit des fosses appropriées par décapage au plasma et que l'on remplit ensuite les fosses avec un matériau électriquement isolant.

6. Procédé selon l'une des revendications précédentes,
caractérisé
par le fait que l'on recouvre le fond (11) de chaque évidement (9) d'une couche d'oxyde de silicium (15).

7. Procédé selon l'une des revendications 1 à 5,
caractérisé
par le fait que l'on recouvre les parois (10) et le fond (11) de chaque évidement (9) d'une couche d'oxyde de silicium (15).

8. Procédé selon la revendication 6 ou 7,
caractérisé
par le fait que l'on recouvre tout d'abord d'une couche de Si3N4 les zones du bloc à semiconducteur (1) qui ne doivent pas être oxydées, avant de produire la couche d'oxyde de silicium (5) par oxydation thermique.

9. Procédé selon l'une des revendications 6 à 8,
caractérisé
par le fait que l'on revêt la couche d'oxyde de silicium (5) d'une couche électriquement non conductrice (16).

10. Procédé selon l'une des revendications précédentes,
caractérisé
par le fait que l'on remplit chaque évidement (9) au moins partiellement d'un matériau de remplissage (21).

11. Procédé selon l'une des revendications précédentes,
caractérisé
par le fait que dans le bloc à semiconducteur (1) on produit au moins une fosse qui sert de fenêtre de test (23), qui coïncide en profondeur avec les fosses de séparation (6') prévues pour les parois électriquement isolantes (6) et dont la largeur est supérieure à celle des fosses de séparation, et que l'on réduit l'épaisseur du bloc à semiconducteur (1) jusqu'à ce que le fond de la fosse soit percé.
